# EUROPEAN PATENT APPLICATION

(11) **EP 4 276 078 A1**
(43) Date of publication of application: **15.11.2023**
(21) Application number: 23739841.7
(22) Date of filing: 03.01.2023
(51) Int. Cl.: C03C 10/16, C03C 10/04, C03C 3/112, C03C 3/097

(54) **ELECTRONIC DEVICE**

(30) Priority: 17.01.2022 CN 202210058886
(71) Applicant: Honor Device Co., Ltd., Shenzhen, Guangdong 518040 (CN)
(72) Inventor: HAN, Shuai, Shenzhen, Guangdong 518040 (CN); XU, Wenbin, Shenzhen, Guangdong 518040 (CN)
(74) Representative: Maiwald GmbH
(86) International application number: PCT/CN2023/070077
(87) International publication number: WO 2023/134497

(57) **Abstract**

Embodiments of this application provide microcrystalline glass, which is obtained by performing microcrystallization on mother glass. In this application, microcrystallization is performed on the mother glass, so that nano microcrystalline particles are precipitated from the mother glass to obtain the microcrystalline glass. The nano-sized microcrystalline particles can slow down stress concentration at a crack tip, to deflect and hinder microcrack propagation, thereby improving anti-drop performance of glass. An experimental result shows that after microcrystallization is performed on the glass provided in the present invention, fracture toughness of the glass is 1.0 MPa·m^{1/2} or more, which is improved by 20% or more coMPared with that of glass without microcrystallization; and a ball drop height of the glass is 1000 mm or more, which is improved by 30% or more coMPared with that of glass without microcrystallization. In addition, in this application, microcrystallization has no iMPact on transmittance of the glass, and transmittance of the obtained microcrystalline glass is 88% or more (1 mm thick) at a wavelength of 400 nm~1000 nm, which is not obviously decreased coMPared with that of glass without microcrystallization.

## Description

This application claims priority to Chinese Patent Application No. 202210058886.X, filed with the China National Intellectual Property Administration on January 17, 2022 and entitled "MICROCRYSTALLINE GLASS AND MANUFACTURING METHOD THEREFOR, STRENGTHENED GLASS AND MANUFACTURING METHOD THEREFOR, HOUSING OF ELECTRONIC DEVICE, DISPLAY SCREEN OF ELECTRONIC DEVICE, AND ELECTRONIC DEVICE", which is incorporated herein by reference in its entirety.

### TECHNICAL FIELD

This application relates to the field of electronic device technologies, and in particular, to microcrystalline glass and a manufacturing method therefor, strengthened glass and a manufacturing method therefor, a housing of an electronic device, a display screen of an electronic device, and an electronic device.

### BACKGROUND

Since the advent of smartphones, a material of a cover has gradually developed from a plastic material to a glass material, and glass in a backplane material has stood out from many materials, such as plastics, metals, and ceramics, because of its advantages such as sufficient wear resistance, plasticity, high cost performance, and support for wireless charging, and has become a mainstream choice for medium- and high-end mobile phones. However, the glass material has a major disadvantage, that is, poor anti-drop performance.

To improve anti-drop performance of mobile phone glass, the industry has improved and optimized the glass mainly from two aspects: One is to improve glass composition, which has gradually developed from soda-lime silicate glass to high aluminosilicate glass, as well as super ceramic crystal glass in recent years; and the other is to optimize a chemical strengthening process of glass, which has developed an ion exchange process from a one-step method to a two-step method and a multi-step method. The super ceramic crystal glass is microcrystalline glass, which improves fracture toughness (K_{IC}) and anti-drop performance of glass by using a microcrystalline phase in the glass.

### SUMMARY

This application provides microcrystalline glass and a manufacturing method therefor, strengthened glass and a manufacturing method therefor, a housing of an electronic device, a display screen of an electronic device, and an electronic device, to improve fracture toughness and anti-drop performance of glass, and resolve a technical problem that the glass has poor anti-drop performance as a housing of an electronic device or an outer screen of a display screen.

To achieve the foregoing objective, this application provides the following technical solutions.

Microcrystalline glass is provided, which is obtained by performing microcrystallization on mother glass. The mother glass includes:
50 mol%~70 mol% SiO₂;
20 mol%~30 mol% Li₂O+Na₂O+K₂O;
1 mol%~15 mol% CaO+SrO+BaO;
1 mol%~5 mol% Al₂O₃;
0.5 mol%~3 mol% F⁻;
0.05 mol%~5 mol% P₂O₅;
0-0.5 mol% Mn₂O₃;
0-0.5 mol% CuO;
0-0.5 mol% FeO; and
0-1 mol% Mn₂0₃+CuO+FeO, where
CaO and SrO are not 0 simultaneously; and
Li₂O and Na₂O are not 0 simultaneously.

In this application, microcrystallization is performed on the mother glass with the foregoing components, so that nano microcrystalline particles are precipitated from the mother glass to obtain the microcrystalline glass. The nano-sized microcrystalline particles can slow down stress concentration at a crack tip, to deflect and hinder microcrack propagation, thereby improving anti-drop performance of glass. An experimental result shows that after microcrystallization is performed on the glass provided in the present invention, fracture toughness of the glass is 1.0 MPa·m^{1/2} or more, which is improved by 20% or more coMPared with that of glass without microcrystallization; and a ball drop height of the glass is 1000 mm or more, which is improved by 30% or more coMPared with that of glass without microcrystallization. In addition, in this application, microcrystallization has no iMPact on transmittance of the glass, and transmittance of the obtained microcrystalline glass is 88% or more (1 mm thick) at a wavelength of 400 nm~1000 nm, which is not obviously decreased coMPared with that of glass without microcrystallization. Moreover, microcrystallization causes an obvious decrease in transparency of the obtained glass, and the glass may be used as a non-display area of an electronic device.

In an example embodiment, the mother glass includes:
55 mol%~65 mol% SiO₂;
20 mol%~30 mol% Li₂O;
0-5 mol% Na₂O;
0-5 mol% K₂O;
1 mol%~10 mol% CaO;
1 mol%~10 mol% SrO;
0-5 mol% BaO;
1 mol%~3 mol% Al₂O₃;
0.5 mol%~2 mol% F⁻;
1 mol%~3 mol% P₂O₅;
0-0.5 mol% Mn₂O₃;
0-0.5 mol% CuO;
0-0.5 mol% FeO; and
0-1 mol% Mn₂O₃+CuO+FeO.

In another example embodiment, the mother glass includes:
58 mol%~65 mol% SiO₂;
23 mol%~29 mol% Li₂O;
0-3 mol% Na₂O;
0-3 mol% K₂O;
3 mol%~8 mol% CaO;
3 mol%~8 mol% SrO;
1-5 mol% BaO;
1 mol%~2 mol% Al₂O₃;
0.5 mol%-1.5 mol% F⁻;
1 mol%~2 mol% P₂O₅;
0-0.5 mol% Mn₂O₃;
0-0.5 mol% CuO;
0-0.5 mol% FeO; and
0-1 mol% Mn₂O₃+CuO+FeO.

According to microcrystalline glass provided in an example embodiment of this application, a microcrystalline phase of the microcrystalline glass includes one or both of Ca₅(PO₄)₃F and Sr₅(PO₄)₃F, and one or both of Li₂Si₂O₅ and Li₂SiO₃. Introduction of F⁻ can promote formation of a large quantity of nano microcrystal nuclei in a system. In addition, F⁻ itself can be used as a nucleation center, which also greatly increases a quantity of crystal nuclei. The crystal nuclei affect each other during growth, which inhibits growth of a crystal, so that an average particle size is small and crystallinity is high. Further, F⁻ can form a nano microcrystalline particle Ca₅(PO₄)₃F or Sr₅(PO₄)₃F with P₂O₅, Ca, and Sr, thereby obtaining microcrystalline glass, and improving anti-drop performance of the microcrystalline glass.

An embodiment of this application further provides chemically strengthened glass, which is obtained by performing microcrystallization and chemical strengthening on mother glass. The mother glass includes:
50 mol%~70 mol% SiO₂;
20 mol%~30 mol% Li₂O+Na₂O+K₂O;
1 mol%~15 mol% CaO+SrO+BaO;
1 mol%~5 mol% Al₂O₃;
0.5 mol%~3 mol% F⁻;
0.05 mol%~5 mol% P₂O₅;
0-0.5 mol% Mn₂O₃;
0-0.5 mol% CuO;
0-0.5 mol% FeO; and
0-1 mol% Mn₂0₃+CuO+FeO, where
CaO and SrO are not 0 simultaneously; and
Li₂O and Na₂O are not 0 simultaneously.

In this embodiment of this application, chemical strengthening is performed on microcrystalline glass to form a compressive stress layer on a surface of the glass, thereby further improving performance such as fracture toughness of the glass. An experimental result shows that a ball drop height of the strengthened glass obtained after chemical strengthening can reach 1300 mm or more, and surface stress of the strengthened glass can reach 450 MPa or more.

In an example embodiment, the mother glass includes:
55 mol%~65 mol% SiO₂;
20 mol%~30 mol% Li₂O;
0-5 mol% Na₂O;
0-5 mol% K₂O;
1 mol%~10 mol% CaO;
1 mol%~10 mol% SrO;
0-5 mol% BaO;
1 mol%~3 mol% Al₂O₃;
0.5 mol%~2 mol% F⁻;
1 mol%~3 mol% P₂O₅;
0-0.5 mol% Mn₂O₃;
0-0.5 mol% CuO;
0-0.5 mol% FeO; and
0-1 mol% Mn₂O₃+CuO+FeO.

In another example embodiment, the mother glass includes:
58 mol%~65 mol% SiO₂;
23 mol%~29 mol% Li₂O;
0-3 mol% Na₂O;
0-3 mol% K₂O;
3 mol%~8 mol% CaO;
3 mol%~8 mol% SrO;
1-5 mol% BaO;
1 mol%~2 mol% Al₂O₃;
0.5 mol%-1.5 mol% F⁻;
1 mol%~2 mol% P₂O₅;
0-0.5 mol% Mn₂O₃;
0-0.5 mol% CuO;
0-0.5 mol% FeO; and
0-1 mol% Mn₂O₃+CuO+FeO.

The glass provided in this application may be used as a cover of a housing of an electronic device or a backplane of a display screen of an electronic device, so that the electronic device has features such as drop resistance and good anti-drop performance while having advantages of a glass material such as wear resistance, high cost performance, and support for wireless charging.

This application further separately provides a manufacturing method for the microcrystalline glass in the foregoing technical solution and a manufacturing method for the chemically strengthened glass in the foregoing technical solution. Microcrystallization can be performed on mother glass to obtain the microcrystalline glass. In an example embodiment, the microcrystallization is performed at 400~800°C for 30-600 min.

Chemical strengthening can be further performed on the microcrystalline glass to obtain the chemically strengthened glass. In an example embodiment, the chemical strengthening includes: performing ion exchange on phase-separated glass in a molten potassium salt. In another example embodiment, the chemical strengthening includes: performing the first ion exchange on the phase-separated glass in a first molten salt, and then performing the second ion exchange in a second molten salt, where the first molten salt is a mixed molten salt of potassium nitrate and sodium nitrate, and the second molten salt is potassium nitrate.

This application provides a housing of an electronic device, including the microcrystalline glass or the chemically strengthened glass in the foregoing technical solution. For example, the microcrystalline glass or the chemically strengthened glass may be used as a material of a backplane of the electronic device, so that drop resistance performance of the electronic device is improved while the electronic device has advantages of a glass material such as aesthetic appearance and high wear resistance.

This application provides a display screen of an electronic device, including the microcrystalline glass or the chemically strengthened glass in the foregoing technical solution. For example, the microcrystalline glass or the chemically strengthened glass may be used as a material of a cover of the electronic device, that is, used as an outer screen of the electronic device, to improve drop resistance performance of the electronic device and prolong a service life of the electronic device.

This application further provides an electronic device, including at least one of the housing in the foregoing technical solution and the display screen in the foregoing technical solution. The electronic device has features such as drop resistance and good anti-drop performance while having advantages such as wear resistance, high cost performance, and support for wireless charging.

It should be understood that descriptions of technical features, technical solutions, beneficial effects, or similar expressions in this application do not imply that all features and advantages can be achieved in any single embodiment. On the contrary, it can be understood that the descriptions of the features or the beneficial effects mean that specific technical features, technical solutions, or beneficial effects are included in at least one embodiment. Therefore, the descriptions of the technical features, the technical solutions, or the beneficial effects in the specification do not necessarily mean the same embodiment. Further, the technical features, the technical solutions, and the beneficial effects described in the embodiments may be combined in any appropriate manner. A person skilled in the art understand that an embodiment can be implemented without one or more specific technical features, technical solutions, or beneficial effects of a specific embodiment. In other embodiments, additional technical features and beneficial effects may also be identified in specific embodiments that do not reflect all embodiments.

### BRIEF DESCRIPTION OF DRAWINGS

FIG. 1 is a schematic diagram of a morphology of microcrystalline glass;
FIG. 2 is a TEM image of microcrystalline glass; and
FIG. 3 shows transmittance curves of glass according to Embodiment 2-1 of the present invention and CoMParative Example 2.

### DESCRIPTION OF EMBODIMENTS

The following clearly and completely describes technical solutions in embodiments of this application with reference to the accoMPanying drawings in the embodiments of this application. The terms used in the following embodiments are merely intended to describe specific embodiments, but not intended to limit this application. As used in the specification and the appended claims of this application, singular expressions "one", "a", "the", "the foregoing", "this", and "this" are also intended to include an expression such as "one or more", unless contrary indication is clearly specified in the context. It should be further understood that in the embodiments of this application, "one or more" means one, two, or more than two, and "and/or" describes an association relationship between associated objects and indicates that three relationships may exist. For example, A and/or B may indicate the following cases: Only A exists, both A and B exist, and only B exists, where A and B may be singular or plural. The character "/" usually indicates an "or" relationship between associated objects.

As described in the specification, referring to "one embodiment" or "some embodiments" or the like means that one or more embodiments of this application include particular features, structures, or characteristics described with reference to the embodiments. Therefore, statements such as "in one embodiment", "in some embodiments", "in some other embodiments", and "in some other embodiments" that appear in different parts of the specification do not necessarily refer to same embodiments, but mean "one or more but not all embodiments" unless otherwise specifically emphasized in another manner. The terms "include", "comprise", "have", and variants thereof all mean "include but is not limited to", unless otherwise specifically emphasized in another manner.

"A plurality of" in the embodiments of this application means "greater than or equal to two". It should be noted that in the description of the embodiments of this application, words such as "first" and "second" are merely used for distinguishing between descriptions, and cannot be understood as an indication or implication of relative importance, or cannot be understood as an indication or implication of a sequence.

In the embodiments of this application, words such as "an example" or "for example" are used to represent giving an example, an illustration, or a description. Any embodiment or design solution described as "an example" or "for example" in the embodiments of this application should not be construed as being more preferred or having more advantages than other embodiments or design solutions. Exactly, use of the words such as "an example" or "for example" is intended to present a related concept in a specific manner.

In this application, mother glass refers to glass obtained from raw materials through mixing, melting, and cooling and forming, which is a raw material for manufacturing microcrystalline glass and is used to distinguish from microcrystalline glass obtained after microcrystallization and strengthened glass obtained after ion exchange, and has no other special meaning.

In this application, compressive stress is a value obtained by dividing a compressive load applied to a sample by an original cross-sectional area of the sample during a compression test, and is used to represent glass performance.

In this application, a glass-generating body, also referred to as a glass-generating object or a glass network-forming object, refers to an oxide that can separately form a glass network structure, including but not limited to silicon dioxide, boron oxide, and the like. A network modifier, also referred to as a glass network modifier or glass regulator, refers to an oxide that cannot separately form a network constituting glass but can change a network, including but not limited to sodium oxide, potassium oxide, magnesium oxide, lithium oxide, barium oxide, and the like. A network intermediate, also referred to as a glass network intermediate oxide, refers to an oxide whose performance is between performance of the glass-generating body and performance of the network modifier, including but not limited to aluminum oxide, lead oxide, and the like.

In this application, a backplane is a part of a housing of an electronic device, which may also be referred to as a battery cover or a back cover, and is configured to protect a battery. A cover is a part of a display screen of an electronic device, which may also be referred to as an outer screen of the display screen, and is configured to protect an inner screen with a display function in the display screen.

Dropping damage of glass is mainly caused by propagation of an original microcrack in the glass, and microcrack propagation is related to stress concentration at a crack tip on a material surface. Microcrystalline glass slows down stress concentration at the crack tip by using nano-sized microcrystalline particles in the glass, to deflect and hinder microcrack propagation, thereby improving anti-drop performance of the glass.

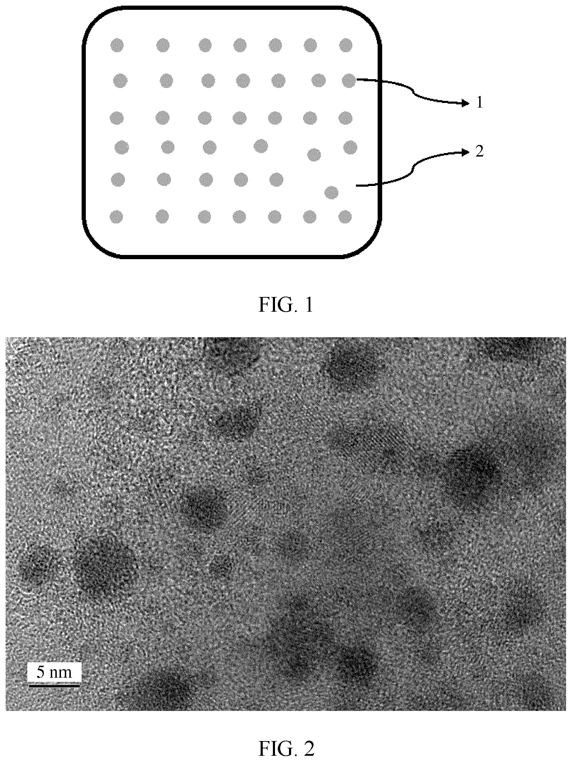

Microcrystalline glass has a microcrystalline phase. As shown in FIG. 1, FIG. 1 is a schematic diagram of a morphology of microcrystalline glass, where "1" indicates a microcrystalline phase and "2" indicates a glass phase. The microcrystalline phase can inhibit crack propagation, to improve mechanical strength of glass such as a Young's modulus and fracture toughness. After chemical strengthening, mechanical performance of the glass, such as anti-drop performance, compression resistance, and scratch resistance, is further improved, so that the microcrystalline glass can be applied to an electronic device. Currently, the microcrystalline phase of the microcrystalline glass is usually a nano microcrystalline particle Li₂Si₂O₅ or Li₂SiO₃. Although anti-drop performance of the microcrystalline glass having the microcrystalline phase is improved coMPared with glass without microcrystallization, for example, a ball drop height of the microcrystalline glass can be increased from 600 mm to 700 mm or even 800 mm, anti-drop performance of the microcrystalline glass still needs to be further improved.

The glass provided in this application is obtained by performing microcrystallization and chemical strengthening on mother glass, may be used as a backplane or a cover of a mobile phone, and may also be used in electronic devices such as watches and tablets.

In an embodiment, components forming the mother glass include:
50 mol%~70 mol% SiO₂;
20 mol%~30 mol% Li₂O+Na₂O+K₂O;
1 mol%~15 mol% CaO+SrO+BaO;
1 mol%~5 mol% Al₂O₃;
0.5 mol%~3 mol% F⁻;
0.05 mol%~5 mol% P₂O₅;
0-0.5 mol% Mn₂O₃;
0-0.5 mol% CuO;
0-0.5 mol% FeO; and
0-1 mol% Mn₂0₃+CuO+FeO, where
CaO and SrO are not 0 mol% simultaneously; and
Li₂O and Na₂O are not 0 mol% simultaneously.

In this embodiment, SiO₂ is used as a main component of the glass. As a glass-generating body, SiO₂ iMParts superior structural stability, chemical stability, mechanical performance, and forming performance to the mother glass. In an embodiment, the content of SiO₂ is 50 mol%~70 mol%. In an embodiment, the content of SiO₂ is 55 mol%~65 mol%. In an embodiment, the content of SiO₂ is 58 mol%~65 mol%.

In an embodiment, Li₂O can form a nano microcrystalline particle Li₂Si₂O₅ or Li₂SiO₃ with SiO₂, to be precipitated from the glass to convert the mother glass into the microcrystalline glass. In an embodiment, the content of Li₂O is 20-30 mol%. In an embodiment, the content of Li₂O is 23-29 mol%.

In other embodiments, Li₂O may be used a network modifier component to reduce a melting viscosity layer of the glass and accelerate melting and refining of the glass. In an embodiment, the content of Li₂O is 0-7 mol%. In an embodiment, the content of Li₂O is 1-5 mol%.

In one aspect, Na₂O can reduce viscosity of glass liquid, and is used as a co-solvent for manufacturing the glass. In another aspect, Na₂O is used for subsequent ion exchange with K⁺, to generate high compressive stress on a glass surface. In an embodiment, the content of Na₂O is 0-5 mol%. In an embodiment, the content of Na₂O is 0-3 mol%.

K₂O can improve a glass melting and refining effect. In an embodiment, the content of K₂O is 0-5 mol%. In an embodiment, the content of K₂O is 0 mol%~3 mol%.

In an embodiment, the total content of Li₂O+Na₂O+K₂O is 20 mol%~30 mol%. In order that subsequent chemical strengthening can be performed smoothly, contents of Li₂O and Na₂O are not 0 simultaneously.

As a network intermediate, Al₂O₃ can improve exfoliation stability and mechanical performance of the glass. In an embodiment, the content of Al₂O₃ is 1 mol%~5 mol%. In an embodiment, the content of Al₂O₃ is 1 mol%~3 mol%. In an embodiment, the content of Al₂O₃ is 1 mol%~2 mol%.

As glass network modifier components, CaO, SrO, and BaO can reduce a glass melting temperature and facilitate refining. In addition, Ca and Sr can form a nano microcrystalline particle Ca₅(PO₄)₃F or Sr₅(PO₄)₃F with P₂O₅ and F⁻, thereby improving anti-drop performance of the microcrystalline glass. In an embodiment, the content of CaO+SrO+BaO is 1 mol%~15 mol%, and contents of CaO and SrO are not 0 simultaneously. In an embodiment, the content of CaO is 1-10 mol%. In an embodiment, the content of SrO is 1-10 mol%. In an embodiment, the content of BaO is 0-5 mol%. In an embodiment, the content of CaO is 3-8 mol%. In an embodiment, the content of SrO is 3-8 mol%. In an embodiment, the content of BaO is 1-5 mol%.

In this application, F⁻ is introduced into glass. Introduction of F⁻ can promote formation of a large quantity of nano microcrystal nuclei in a system. In addition, F⁻ itself can be used as a nucleation center, which also greatly increases a quantity of crystal nuclei. The crystal nuclei affect each other during growth, which inhibits growth of a crystal, so that an average particle size is small and crystallinity is high. Further, F⁻ can form a nano microcrystalline particle Ca₅(PO₄)₃F or Sr₅(PO₄)₃F with P₂O₅, Ca, and Sr, thereby obtaining microcrystalline glass, and improving anti-drop performance of the microcrystalline glass. In an embodiment, the content of F⁻ is 0.5 mol%~3 mol%. In an embodiment, the content of F⁻ is 0.5 mol%~2 mol%. In an embodiment, the content of F⁻ is 0.5 mol%-1.5 mol%.

As a glass-forming body, P₂O₅ forms a layered network structure, which facilitates ion diffusion in the glass and promotes chemical strengthening. In addition, P₂O₅ can form a nano microcrystalline particle Ca₅(PO₄)₃F or Sr₅(PO₄)₃F with F⁻, Ca, and Sr. In an embodiment, the content of P₂O₅ is 0.05 mol%~5 mol%. In an embodiment, the content of P₂O₅ is 1 mol%~3 mol%. In an embodiment, the content of P₂O₅ is 1 mol%~2 mol%.

As a colorant, Mn₂O₃ can change a color of the glass, for example, changing the glass to purple. In an embodiment, the content of Mn₂O₃ is 0-0.5 mol%.

As a colorant, CuO can change a color of the glass, for example, changing the glass to blue; or can adjust the color of the glass with other colorants, such as MnO₂ and Nd₂O₃. In an embodiment, the content of CuO is 0-0.5 mol%.

As a colorant, FeO can change a color of the glass, for example, changing the glass to blue. In an embodiment, the content of FeO is 0-0.5 mol%.

In an embodiment, the content of Mn₂O₃+CuO+FeO is 0-1 mol%. In an embodiment, the content of Mn₂O₃+CuO+FeO is 0-0.5 mol%.

In an embodiment, components forming the mother glass include:
55 mol%~65 mol% SiO₂;
20 mol%~30 mol% Li₂O;
0~5 mol% Na₂O;
0-5 mol% K₂O;
20 mol%~30 mol% Li₂O+Na₂O+K₂O;
1 mol%~10 mol% CaO;
1 mol%~10 mol% SrO;
0-5 mol% BaO;
1 mol%~15 mol% CaO+SrO+BaO;
1 mol%~3 mol% Al₂O₃;
0.5 mol%~2 mol% F⁻;
1 mol%~3 mol% P₂O₅;
0-0.5 mol% Mn₂O₃;
0-0.5 mol% CuO;
0-0.5 mol% FeO; and
0-1 mol% Mn₂O₃+CuO+FeO.

After microcrystallization and chemical strengthening are performed on the mother glass with the foregoing components, anti-drop performance of the mother glass is further improved.

In an embodiment, components forming the mother glass include:
58 mol%~65 mol% SiO₂;
23 mol%~29 mol% Li₂O;
0-3 mol% Na₂O;
0-3 mol% K₂O;
20 mol%~30 mol% Li₂O+Na₂O+K₂O;
3 mol%~8 mol% CaO;
3 mol%~8 mol% SrO;
1-5 mol% BaO;
1 mol%~15 mol% CaO+SrO+BaO;
1 mol%~2 mol% Al₂O₃;
0.5 mol%-1.5 mol% F⁻;
1 mol%~2 mol% P₂O₅;
0-0.5 mol% Mn₂O₃;
0~0.5 mol% CuO;
0-0.5 mol% FeO; and
0-1 mol% Mn₂O₃+CuO+FeO.

After microcrystallization and chemical strengthening, especially chemical strengthening, are performed on the mother glass with the foregoing components, anti-drop performance of the mother glass is more prominent.

In an embodiment, the mother glass is transparent glass, and transmittance of the mother glass is 90% or more (1 mm thick) at a wavelength of 400 nm~1000 nm.

A manufacturing method for the mother glass is not specially limited in this application. For example, the mother glass can be obtained by uniformly mixing and stirring raw materials, heating to fully melting, and cooling and forming. In an embodiment, a melting temperature is 1400~1600°C, and melting temperature preservation time is 50-120 min. It can be understood that during manufacturing of the mother glass, in the melting process, homogenization can be performed by using a method such as deaeration or stirring. A specific method for cooling and forming includes but is not limited to forming plate glass by using a float process, a down-draw process, a pressing process, or a flat rolling process, or forming bulk glass through casting.

The raw material used for manufacturing the mother glass in the present invention may be an oxide, a composite oxide, a carbonate, a hydroxide, a hydrate thereof, and the like. For example, the oxide may be silica sand (SiO₂), alumina (Al₂O₃), copper oxide (CuO), or the like. The composite oxide may be sodium metaphosphate (NaPO₃), aluminum metaphosphate (Al(PO₃)₃), aluminum fluoride (AlF₃), or the like. The carbonate may be sodium carbonate, potassium carbonate, calcium carbonate, strontium carbonate, or the like. The hydroxide may be aluminum hydroxide or the like. The hydrate may be phosphoric acid or the like.

After the mother glass is obtained, microcrystallization is performed on the mother glass. During the processing, corresponding components can form nano microcrystallization particles to be precipitated from a glass phase to obtain microcrystalline glass. In this application, heat treatment is performed on the mother glass to microcrystallize the mother glass. During the heat treatment, the nano microcrystallization particles undergo two processes: crystal nucleus nucleation and crystal nucleus growth. Types, sizes, and contents of the precipitated nano microcrystallization particles can be adjusted by controlling different nucleation and growth time and temperatures. This is not specially limited in the present invention. In an embodiment, the heat treatment is performed at 400~800°C for 30-600 min. In an embodiment, the heat treatment is performed at 450~750°C for 40-400 min. In an embodiment, the heat treatment is performed at 500~650°C for 50-350 min.

After microcrystallization is performed on the mother glass provided in this embodiment of this application, the precipitated nano microcrystalline particles include at least one of crystalline phases Ca₅(PO₄)₃F and Sr₅(PO₄)₃F, and may further include one or more of Li₂Si₂O₅ and Li₂SiO₃. The precipitated nano microcrystalline particles are usually spherical nano microcrystalline particles and usually have a size of 1 nm~300 nm. As shown in FIG. 2, FIG. 2 is a TEM image of microcrystalline glass according to Embodiment 2-1 of the present invention. In an embodiment, the nano microcrystalline particles have an average particle size of 1-100 nm, and a content of the nano microcrystalline particles occupies 50% or more of the entire microcrystalline glass. In an embodiment, the nano microcrystalline particles have an average particle size of 1~50 nm, and a content of the nano microcrystalline particles occupies 80% or more of the entire microcrystalline glass.

After microcrystallization, the nano microcrystalline particles precipitated from the glass phase can effectively hinder microcrack propagation in the glass, to improve mechanical strength such as fracture toughness of the glass, thereby improving anti-drop performance of the glass. An experimental result shows that after microcrystallization is performed on the glass provided in the present invention, fracture toughness of the glass is 1.0 MPa·m^{1/2} or more, which is improved by 20% or more; and a ball drop height of the glass is 1000 mm or more, which is improved by 30% or more.

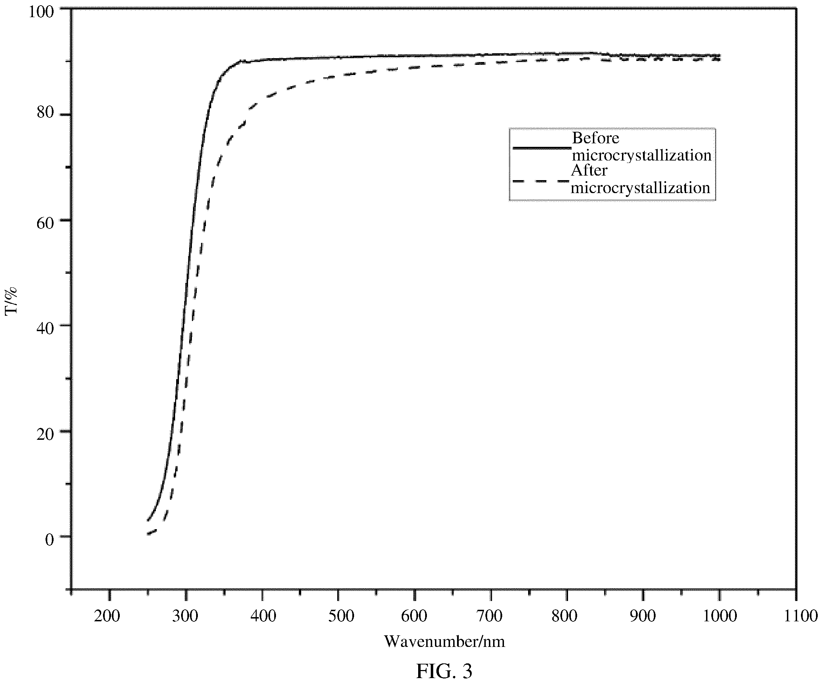

In addition, in this application, microcrystallization has no iMPact on transmittance of the glass, and the obtained microcrystalline glass is still transparent glass, which has transmittance of 88% or more at a wavelength of 400 nm~1000 nm, where preferred transmittance is 90% or more (1 mm thick). The transmittance is not obviously decreased. Referring to FIG. 3, FIG. 3 shows transmittance curves of microcrystalline glass according to Embodiment 2-1 of the present invention and CoMParative Example 2.

In this application, the temperature of the microcrystallization is relatively high, the time of the microcrystallization is relatively long, the content of the nano microcrystalline particles in the glass is relatively high, and transparency of the glass material is obviously reduced. Therefore, the glass may be used as a non-display area in the field of electronic products.

The microcrystalline glass obtained in the present invention may be used as a material of a cover or a backplane of an electronic device, for example, a 2D glass backplane, a 3D glass backplane, a 2.5D glass backplane, a glass cover, or the like of a mobile phone.

In an embodiment, after the microcrystalline glass is obtained, the microcrystalline glass may be further chemically strengthened to further improve performance such as fracture toughness of the glass. Specifically, after the microcrystalline glass is obtained, the microcrystalline glass is processed into a desired shape based on use of the microcrystalline glass and then undergoes chemical strengthening or directly undergoes chemical strengthening. For example, the microcrystalline glass undergoes cutting, CNC shape processing, and polishing to obtain a planar mobile phone backplane; or the microcrystalline glass undergoes cutting, CNC shape processing, 3D hot bending, and polishing to obtain a 3D mobile phone backplane, and so on. The 3D hot bending is to perform hot pressing on a CNC-processed raw glass material by using a hot bending machine in cooperation with a molding die, so that the glass is bent into a required shape, that is, a 3D glass shape.

After being obtained, the microcrystalline glass with the desired shape is chemically strengthened to form a compressive stress layer on a surface of the glass, thereby improving strength of the glass. The chemical strengthening may be performed through one ion exchange or two ion exchanges, to form an ion exchange layer. This is not specially limited in this application.

Specifically, the one ion exchange includes: performing ion exchange on the microcrystalline glass in a molten potassium salt. In an embodiment, the molten potassium salt may be potassium nitrate, and the ion exchange is performed at 400°C~500°C for 4-7 hours. In an embodiment, the ion exchange is performed at 450°C for 6 h.

The two ion exchanges include: performing the first ion exchange on the microcrystalline glass in a first molten salt, and then performing the second ion exchange in a second molten salt. In an embodiment, the first molten salt is a mixed molten salt of potassium nitrate and sodium nitrate, and the first ion exchange is performed at 400~600°C for 80-400 min; and the second molten salt is potassium nitrate, and the second ion exchange is performed at 400~500°C for 20-180 min. In an embodiment, the first molten salt is a mixed molten salt of potassium nitrate and sodium nitrate, and the first ion exchange is performed at 400~500°C for 100-300 min; and the second molten salt is potassium nitrate, and the second ion exchange is performed at 400~500°C for 30-150 min.

After the chemical strengthening, a ball drop height of the obtained strengthened glass can reach 1300 mm or more, and surface stress of the strengthened glass can reach 450 MPa or more.

After the chemical strengthening, subsequent processing such as transfer printing and film coating (AF) can be performed on the glass based on use thereof. This is not specifically limited in this application.

The glass provided in this application may be used as a cover of a housing of an electronic device or a backplane of a display screen of an electronic device, so that the electronic device has features such as drop resistance and good anti-drop performance while having advantages of a glass material such as wear resistance, high cost performance, and support for wireless charging.

The electronic device in this application may be any device with communication and storage functions, such as a smartphone, a cellular phone, a cordless phone, a session initiation protocol (Session Initiation Protocol, SIP) phone, a tablet computer, a personal digital assistant (Personal Digital Assistant, PAD), a notebook computer, a digital camera, an e-book reader, a portable multimedia player, a handheld device with a wireless communication function, a computing device or another processing device connected to a wireless modem, an in-vehicle device, a wearable device, and a 5G terminal device. This is not limited in the embodiments of this application.

The microcrystalline glass and the manufacturing method therefor, the strengthened glass and the manufacturing method therefor, the housing of an electronic device, the display screen of an electronic device, and the electronic device provided in this application are described in detail below with reference to embodiments.

Glass is manufactured based on formulas and process parameters shown in Table 1. A specific method is as follows.

Raw materials such as SiO₂, Li₂CO₃, Na₂CO₃, K₂CO₃, CaCO₃, SrCO₃, BaCO₃, AlF₃, Al(PO₃)₃, and Al₃O₂ are placed into a mortar to be fully and uniformly stirred to obtain a mixed batch, then the mixed batch is transferred to a high-temperature furnace of 1400~1600°C for temperature preservation for 1.5-2 h, so that the mixed batch is fully molten, and further the molten mixed batch is cooled and formed to obtain a transparent mother glass material.

The mother glass is placed into a resistance furnace of 400~800°C to undergo heat treatment for 30-600 min, so that the mother glass undergoes nucleation and growth processes of nano microcrystals at a high temperature, to obtain nano microcrystalline glass.

The nano microcrystalline glass is cut and then undergoes a two-step ion exchange to obtain chemically strengthened glass. The ion exchange specifically includes: The nano microcrystalline glass is soaked in a sodium potassium salt (KNO₃+NaNO₃) solution at a temperature of about 450°C for 200 min and then removed. Further, the nano microcrystalline glass is soaked in a molten potassium salt (KNO₃) solution at a temperature of about 450°C for 100 min and then removed from cleaning.

Performance of the glass is tested. For results, refer to Table 1. A test method is as follows.

For the test of fracture toughness, refer to the national standard GB/T 37900-2019 (Test method of hardness and fracture toughness for ultra-thin glass). Samples are tested by using a low-load Vickers hardness indentation method. It should be noted that in each embodiment, when fracture toughness of the samples is tested after chemical strengthening, 10 Kgf pressure (maximum pressure supported by a detection device) is applied to each sample, but still no crack appears, so that a fracture toughness value after chemical strengthening is not counted. It can be learned that the fracture toughness of the samples after the chemical strengthening is much higher than that before the chemical strengthening.

Surface stress of glass and a depth of an ion exchange layer are measured by a glass surface stress meter SLP-2000. During testing, a refractive index of the sample is set to 1.47, and an optical elasticity constant of the sample is set to 65 nm/cm/MPa.

For a ball drop test, refer to the national standard GB/T 39814-2021 (Test method for iMPact strength of ultrathin glass). The sample is processed to 150 mm×75 mm×0.55 mm. After two surfaces are polished, a 32 g steel ball is used to drop from a specified height, that is, a maximum ball drop test height at which the sample can bear an iMPact without fracturing.

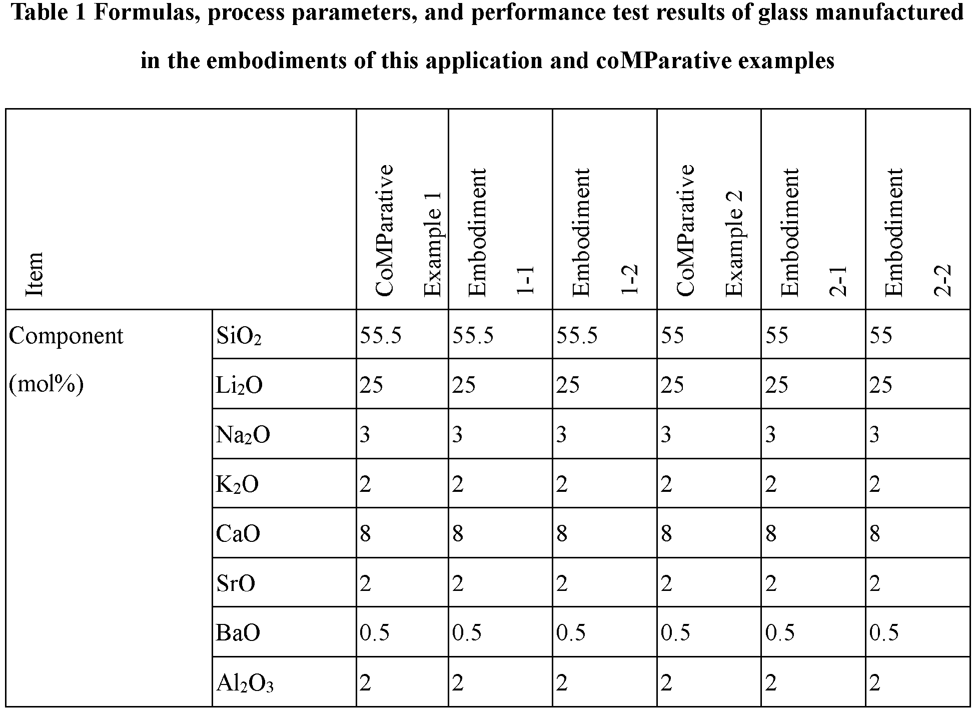

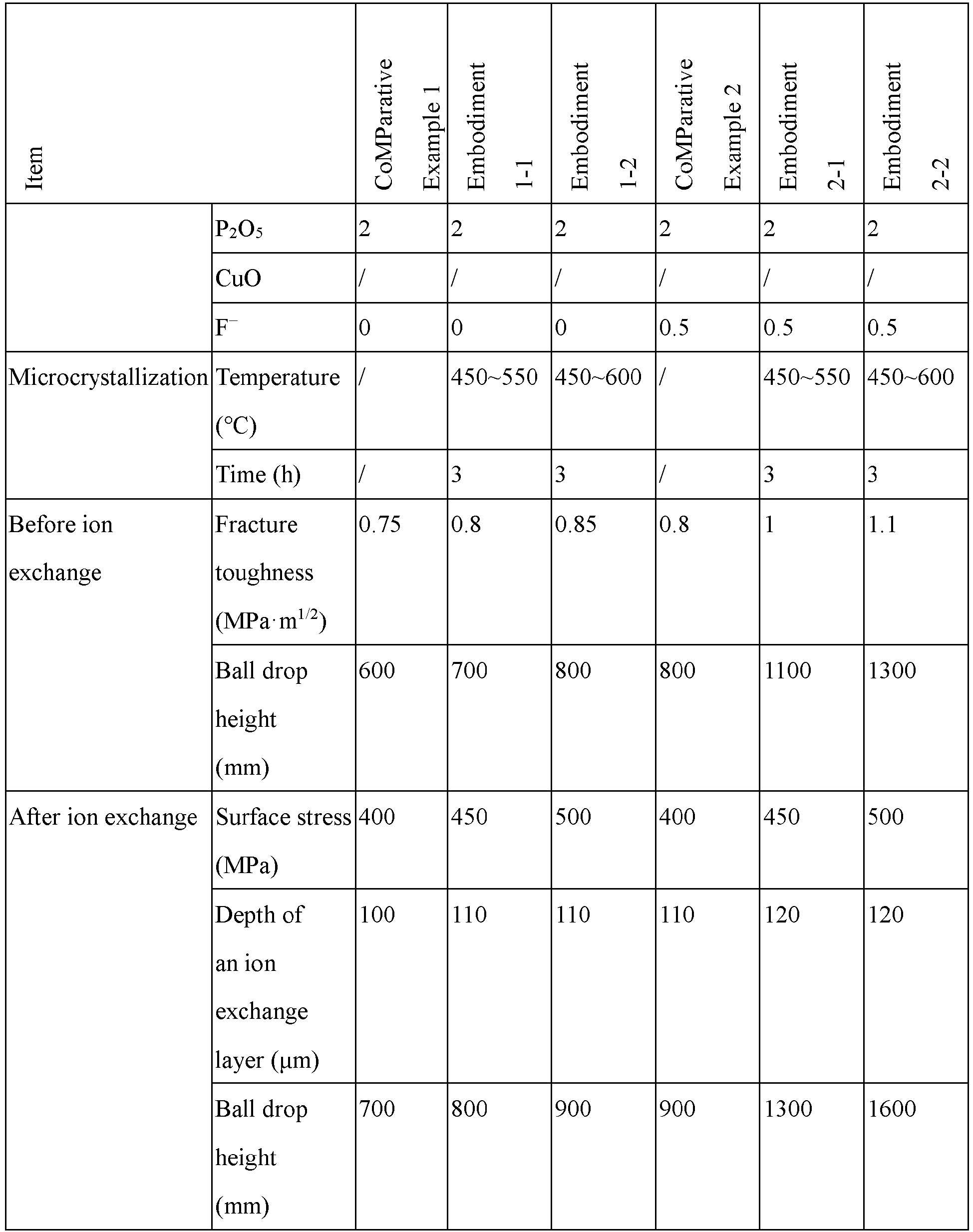

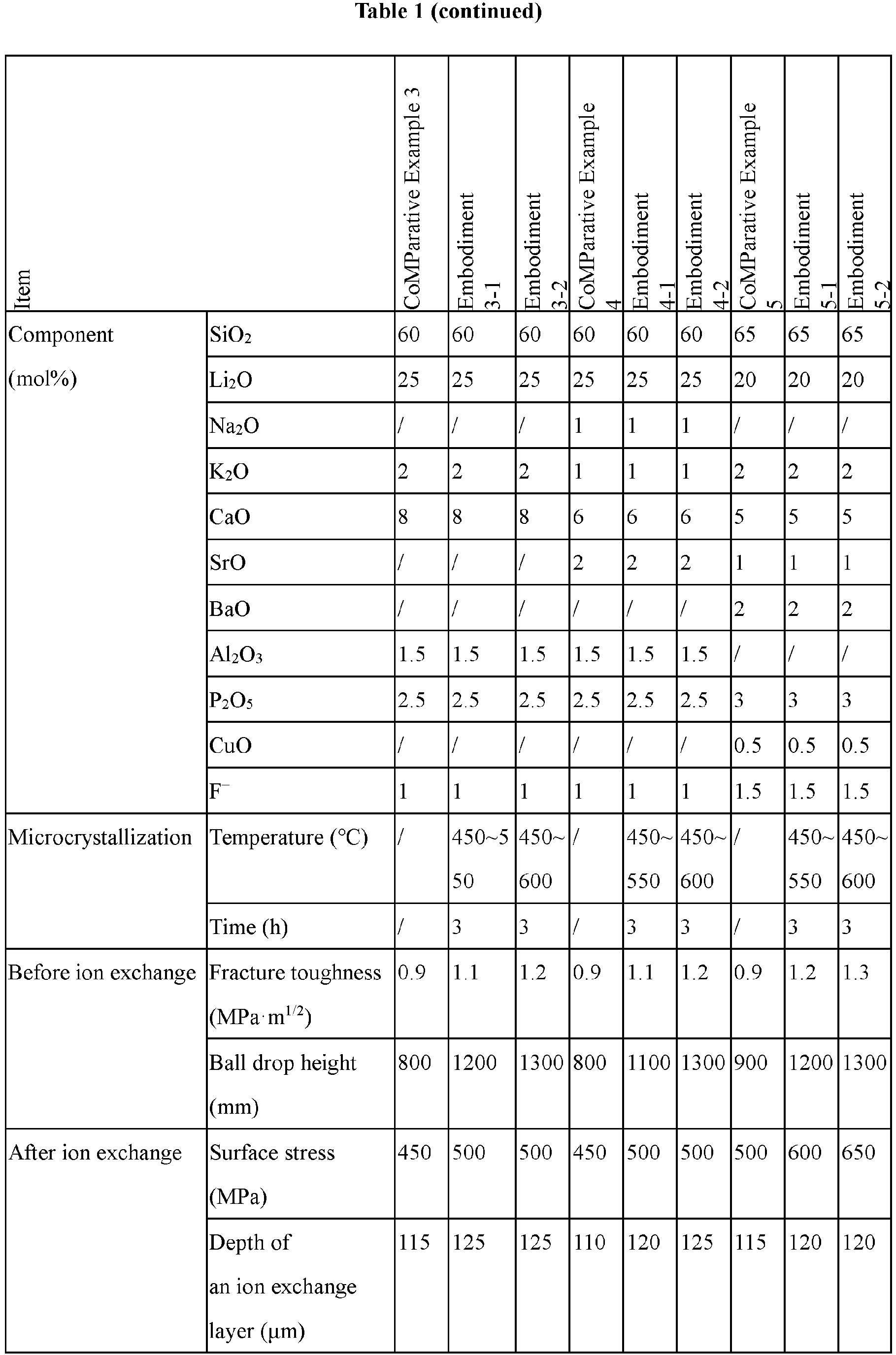

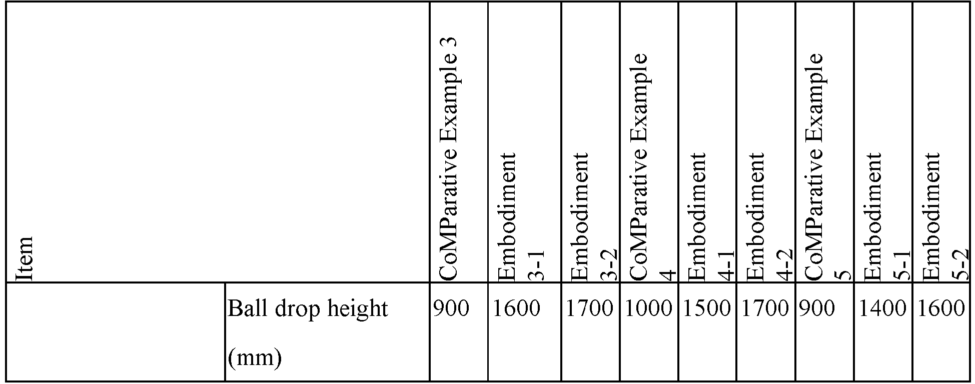

In CoMParative Example 4 and Embodiments 4-1 and 4-2, because a small amount of CuO is added to the glass component design, a color presented by the sample after melting is blue.

It can be learned from Table 1 that after microcrystallization, the fracture toughness and the ball drop height of the glass provided in the present invention are obviously increased, which improves drop resistance performance and anti-drop performance of the glass as a cover or a backplane of an electronic device, especially a mobile phone. Further, after the glass is chemically strengthened, the fracture toughness and the ball drop height of the glass are further increased, and drop resistance performance and anti-drop performance of the glass are improved again. When the glass is used as a cover or a backplane of an electronic device, a service life of the electronic device can be prolonged.

The foregoing descriptions are merely specific implementations of this application, but are not intended to limit the protection scope of this application. Any change or replacement made within the technical scope disclosed in this application shall fall within the protection scope of this application. Therefore, the protection scope of this application shall be subject to the protection scope of the claims.

## Claims

1. Microcrystalline glass, obtained by performing microcrystallization on mother glass, wherein the mother glass comprises:
50 mol%~70 mol% SiO₂;
20 mol%~30 mol% Li₂O+Na₂O+K₂O;
1 mol%~15 mol% CaO+SrO+BaO;
1 mol%~5 mol% Al₂O₃;
0.5 mol%~3 mol% F⁻;
0.05 mol%~5 mol% P₂O₅;
0-0.5 mol% Mn₂O₃;
0-0.5 mol% CuO;
0-0.5 mol% FeO; and
0-1 mol% Mn₂0₃+CuO+FeO, wherein
CaO and SrO are not 0 mol% simultaneously; and
Li₂O and Na₂O are not 0 mol% simultaneously.

2. The microcrystalline glass according to claim 1, wherein the mother glass comprises:
55 mol%~65 mol% SiO₂;
20 mol%~30 mol% Li₂O;
0-5 mol% Na₂O;
0-5 mol% K₂O;
1 mol%~10 mol% CaO;
1 mol%~10 mol% SrO;
0-5 mol% BaO;
1 mol%~3 mol% Al₂O₃;
0.5 mol%~2 mol% F⁻;
1 mol%~3 mol% P₂O₅;
0-0.5 mol% Mn₂O₃;
0-0.5 mol% CuO;
0-0.5 mol% FeO; and
0-1 mol% Mn₂O₃+CuO+FeO.

3. The microcrystalline glass according to claim 2, wherein the mother glass comprises:
58 mol%~65 mol% SiO₂;
23 mol%~29 mol% Li₂O;
0-3 mol% Na₂O;
0-3 mol% K₂O;
3 mol%~8 mol% CaO;
3 mol%~8 mol% SrO;
1-5 mol% BaO;
1 mol%~2 mol% Al₂O₃;
0.5 mol%-1.5 mol% F⁻;
1 mol%~2 mol% P₂O₅;
0-0.5 mol% Mn₂O₃;
0-0.5 mol% CuO;
0-0.5 mol% FeO; and
0-1 mol% Mn₂O₃+CuO+FeO.

4. Microcrystalline glass, wherein a microcrystalline phase of the microcrystalline glass comprises one or both of Ca₅(PO₄)₃F and Sr₅(PO₄)₃F, and one or both of Li₂Si₂O₅ and Li₂SiO₃.

5. The microcrystalline glass according to claim 4, wherein fracture toughness of the microcrystalline glass is 1.0 MPa·m^{1/2} or more.

6. The microcrystalline glass according to claim 5, wherein a ball drop height of the microcrystalline glass is 1000 mm or more.

7. The microcrystalline glass according to claim 6, wherein transmittance of the microcrystalline glass is 88% or more at a wavelength of 400 nm~1000 nm.

8. A manufacturing method for the microcrystalline glass according to any one of claims 1 to 7, comprising the following step:
performing microcrystallization on mother glass to obtain the microcrystalline glass.

9. The manufacturing method according to claim 8, wherein the microcrystallization is performed at 400~800°C for 30-600 min.

10. Chemically strengthened glass, obtained by performing microcrystallization and chemical strengthening on mother glass, wherein the mother glass comprises:
50 mol%~70 mol% SiO₂;
20 mol%~30 mol% Li₂O+Na₂O+K₂O;
1 mol%~15 mol% CaO+SrO+BaO;
1 mol%~5 mol% Al₂O₃;
0.5 mol%~3 mol% F⁻;
0.05 mol%~5 mol% P₂O₅;
0-0.5 mol% Mn₂O₃;
0-0.5 mol% CuO;
0-0.5 mol% FeO; and
0-1 mol% Mn₂O₃+CuO+FeO, wherein
CaO and SrO are not 0 mol% simultaneously; and
Li₂O and Na₂O are not 0 mol% simultaneously.

11. The chemically strengthened glass according to claim 10, wherein the mother glass comprises:
55 mol%~65 mol% SiO₂;
20 mol%~30 mol% Li₂O;
0-5 mol% Na₂O;
0-5 mol% K₂O;
1 mol%~10 mol% CaO;
1 mol%~10 mol% SrO;
0-5 mol% BaO;
1 mol%~3 mol% Al₂O₃;
0.5 mol%~2 mol% F⁻;
1 mol%~3 mol% P₂O₅;
0-0.5 mol% Mn₂O₃;
0-0.5 mol% CuO;
0-0.5 mol% FeO; and
0-1 mol% Mn₂O₃+CuO+FeO.

12. The chemically strengthened glass according to claim 11, wherein the mother glass comprises:
58 mol%~65 mol% SiO₂;
23 mol%~29 mol% Li₂O;
0-3 mol% Na₂O;
0-3 mol% K₂O;
3 mol%~8 mol% CaO;
3 mol%~8 mol% SrO;
1-5 mol% BaO;
1 mol%~2 mol% Al₂O₃;
0.5 mol%-1.5 mol% F⁻;
1 mol%~2 mol% P₂O₅;
0-0.5 mol% Mn₂O₃;
0-0.5 mol% CuO;
0-0.5 mol% FeO; and
0-1 mol% Mn₂O₃+CuO+FeO.

13. Chemically strengthened glass, obtained by performing chemical strengthening on microcrystalline glass, wherein a microcrystalline phase of the microcrystalline glass comprises one or both of Ca₅(PO₄)₃F and Sr₅(PO₄)₃F, and one or both of Li₂Si₂O₅ and Li₂SiO₃.

14. Chemically strengthened glass, comprising a glass phase and a microcrystalline phase, wherein the microcrystalline phase comprises one or both of Ca₅(PO₄)₃F and Sr₅(PO₄)₃F, and one or both of Li₂Si₂O₅ and Li₂SiO₃; and
a surface of the chemically strengthened glass has a compressive stress layer.

15. Chemically strengthened glass, comprising a glass phase and a microcrystalline phase, wherein the microcrystalline phase comprises one or both of Ca₅(PO₄)₃F and Sr₅(PO₄)₃F, and one or both of Li₂Si₂O₅ and Li₂SiO₃; and
a surface of the chemically strengthened glass has an ion exchange layer.

16. The chemically strengthened glass according to any one of claims 13 to 15, wherein surface stress of the chemically strengthened glass is 450 MPa or more.

17. The chemically strengthened glass according to claim 16, wherein a ball drop height of the chemically strengthened glass is 1300 mm or more.

18. A manufacturing method for the chemically strengthened glass according to any one of claims 13 to 17, comprising the following step:
performing microcrystallization and chemical strengthening on mother glass to obtain the chemically strengthened glass.

19. The manufacturing method according to claim 18, wherein the microcrystallization is performed at 400~800°C for 30-600 min.

20. The manufacturing method according to claim 19, wherein the chemical strengthening specifically comprises:
performing ion exchange on microcrystalline glass in a molten potassium salt; or
the chemical strengthening comprises:
performing the first ion exchange on the phase-separated glass in a first molten salt, and then performing the second ion exchange in a second molten salt, wherein the first molten salt is a mixed molten salt of potassium nitrate and sodium nitrate, and the second molten salt is potassium nitrate.

21. A housing of an electronic device, comprising the microcrystalline glass according to any one of claims 1 to 7 or the chemically strengthened glass according to any one of claims 10 to 17.

22. A display screen of an electronic device, comprising the microcrystalline glass according to any one of claims 1 to 7 or the chemically strengthened glass according to any one of claims 10 to 17.

23. An electronic device, comprising at least one of the housing according to claim 21 and the display screen according to claim 22.
